# EUROPÄISCHE PATENTSCHRIFT

(11) **EP 0 534 116 B1**
(45) Veröffentlichungstag und Bekanntmachung des Hinweises auf die Patenterteilung: **05.11.1997**
(21) Anmeldenummer: 92113751.9
(22) Anmeldetag: 12.08.1992
(51) Int. Cl.: H03K 17/16, H03K 17/04

(54) **Schaltungsanordnung zur Ansteuerung eines MOS-Leistungstransistors**
Circuit for controlling a power MOS transistor
Circuit pour la commande d'un transistor MOS de puissance

(30) Priorität: 24.09.1991 DE 4131783
(43) Veröffentlichungstag der Anmeldung: 31.03.1993
(73) Patentinhaber: SIEMENS AKTIENGESELLSCHAFT, 80333 München (DE)
(72) Erfinder: Zitta, Heinz, Dipl.-Ing., A-9580 Drobollach (AT)

(56) Entgegenhaltungen:
- EP-A- 0 297 932
- US-A- 4 504 779
- US-A- 4 825 099
- US-A- 4 880 997
- PATENT ABSTRACTS OF JAPAN vol. 015, no. 102 (E-1043)12. Maerz 1991

## Beschreibung

Die Erfindung betrifft eine Schaltungsanordnung zur Ansteuerung eines MOS-Leistungstransistors, dessen Ausgangskreis in Reihe zu einer Last liegt und dessen Eingangskreis von einer Steuerstufe gesteuert wird, wobei die Steuerstufe ein CMOS-Inverter ist, der von einer Konstantstromquelle gespeist wird.

Eine derartige Schaltungsanordnung ist aus der EP 0 297 932 bekannt.

Die Ansteuerung von Leistungstransistoren, die vorzugsweise als Schalter eingesetzt werden, ist in der Veröffentlichung U. Tietze, Ch. Schenk: Halbleiter-Schaltungstechnik, Springer-Verlag, 7. Aufl., 1985, S. 554 ff. beschrieben. Hervorgehoben ist, daß MOS-Leistungstransistoren beim Einsatz als Leistungsschalters große Vorteile besitzen, weil kein Durchbruch zweiter Art stattfindet und keine Speicherzeit auftritt. Derartige Leistungstransistoren lassen sich jedoch nicht leistungslos steuern, da sie parasitäre Gate-Drain- bzw. Gate-Source-Kapazitäten besitzen. Bei einem Schalt- bzw. Steuervorgang für den Leistungstransistor ist deshalb jeweils eine Umladung dieser parasitären Kapazitäten erforderlich, der von einer Steuerstufe geliefert werden muß. Ein schneller Steuervorgang erfordert deshalb einen niederohmigen Treiber bzw. eine niederohmige Steuerstufe. Diese Steuerstufe kann ein Komplementär-Emitterfolger oder ein Komplementär-Source-folger bzw. Inverter sein.

Insbesondere bei hohen zu schaltenden Strömen im Amperbereich tritt aufgrund der steilen Schaltflanken bei MOS-Leistungstransistoren eine Störstrahlung auf, die zu Problemen hinsichtlich der elektromagnetischen Verträglichkeit insbesondere bei integrierten Schaltungen führen kann. Für einen integrierten MOS-Leistungsschalter vom SMART-Power-Typ gilt entsprechendes. Derartige Leistungsschalter werden zum Schalten von ohmschen und/oder induktiven Verbrauchern, vorzugsweise auch in Kraftfahrzeugen eingesetzt. Abgesehen von den durch die steilen Schaltflanken des Laststroms möglicherweise verursachten Hochfrequenzstörungen, die nicht akzeptabel sind, steht zu erwarten, daß hinsichtlich der Abstrahlung von Leistungstransistoren zukünftig strengere Vorschriften erlassen werden.

Eine Möglichkeit, Störstrahlung beim Schalten des Leistungstransistors zu vermeiden, besteht darin, den Leistungstransistor langsamer ein- und auszuschalten. Dies kann beispielsweise mit hochohmigen Treibern realisiert werden. Allerdings geht damit der Vorteil des schnelleren Ein- und Ausschaltens von MOS-Leistungstransistoren gegenüber Bipolar-Leistungstransistoren verloren. Den gleichen Effekt hat eine zum Eingangskreis des MOS-Leistungstransistors parallel liegende Kapazität. Da bei einem Steuervorgang, d.h. bei einem Ein- und Ausschalten des Leistungstransistors dessen Gate-Kapazität aufgeladen bzw. entladen werden muß, verlängert eine zusätzliche Kapazität diesen Vorgang. Neben der durch die Umladung der Eingangskapazitäten notwendigen Verzögerungszeit setzt sich die gesamte Schaltverzögerung des Leistungstransistors zusätzlich aus der Anstiegs- bzw. Abfallzeit zusammen. Eine zusätzliche Kapazität im Eingangskreis des Leistungstransistors verlängert zwar auch die Anstiegs- bzw. Abfallzeit, aber vorwiegend die Verzögerungszeit zur Umladung der Kapazitäten. Die Verlängerung der Verzögerungszeit ist aber unerwünscht, da für die Störstrahlung allein die wirksame Schaltflanke, d.h. im wesentlichen die Anstiegs- bzw. Abfallzeit entscheidend sind.

Es ist bekannt, daß die parasitäre Miller-Kapazität eines Transistors vom Eingang her gesehen genauso wirkt wie eine Kapazität parallel zum Transistoreingang. Der Rückkopplungseffekt während des Schaltvorgangs beeinflußt dabei das Verhältnis der Verzögerungszeit zur Flankensteilheit, d.h. zur Anstiegs- bzw. Abfallzeit günstig. Eine weitere Möglichkeit zur Reduzierung der Störstrahlung besteht deshalb darin, eine zusätzliche Miller-Kapazität zwischen Drain und Gate des MOS-Leistungstransistors einzubauen. In integrierten Schaltungen erfordert der Einbau eines zusätzlichen Kondensators jedoch erheblichen Flächenaufwand, so daß diese Lösung nachteilig erscheint.

Der Erfindung liegt die Aufgabe zugrunde, eine Ansteuerschaltung für einen MOS-Leistungstransistor anzugeben, die eine Minimierung der Störstrahlung bei einem Schalt- bzw. Steuervorgang des MOS-Leistungstransistors ermöglicht, ohne die Einschalt- bzw. Ausschaltverzögerung des Leistungstransistors wesentlich zu verlängern.

Diese Aufgabe wird mit den Merkmalen des Patentanspruchs 1 gelöst.

Die Erfindung hat den Vorteil, daß sie im wesentlichen allein die Anstiegs- bzw. Abfallzeit bei einem Steuervorgang des Leistungstransistors so zu reduzieren gestattet, wie es die zulässige Störstrahlung erlaubt, ohne die unerwünschten Verzögerungszeiten zur Umladung der parasitären Eingangskapazitäten des Leistungstransistors wesentlich zu verlängern. Es ist möglich, die Anstiegs- und Abfallzeit bei einem Steuervorgang des Leistungstransistors getrennt im Hinblick auf die zulässige Störstrahlung zu optimieren.

Ausgestaltungen der Erfindung sind in abhängigen Ansprüchen gekennzeichnet.

Nachfolgend wird die Erfindung anhand eines Ausführungsbeispieles näher erläutert. Es zeigen:
- Figur 1: ein Prinzipschaltbild einer erfindungsgemäßen Schaltungsanordnung und
- Figur 2: Signaldiagramme zur Erläuterung der Wirkungsweise der Schaltung gemäß Figur 1.

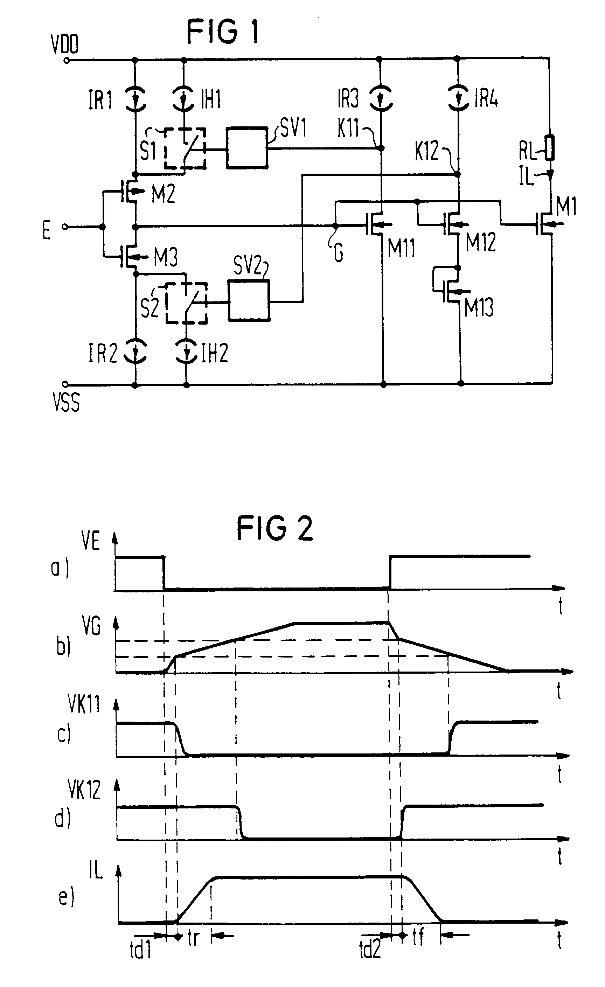

Gemäß Figur 1 enthält die erfindungsgemäße Schaltungsanordnung den Leistungstransistor M1, dessen Ausgangskreis in Reihe zu einer Last RL liegt und dessen Eingangskreis, d.h. dessen Gate von einer Steuerstufe aus den Transistoren M2 und M3 gesteuert wird. Die Steuer- bzw. Treiberstufe enthält als komplementäre Elemente den p-Kanal-Transistor M2 und den n-Kanal-Transistor M3. Beide Transistoren sind als Inverter geschaltet. Das gemeinsam verbundene Gate von M2 und M3 liegt an einer Klemme E zum Empfang der Steuersignale. Der Verbindungspunkt der Ausgangskreise von M2 und M3 ist mit dem Gate von M1 verbunden. Zwischen den sourceseitigen Anschlüssen von M2 bzw. M3 und jeweils einem Pol der Versorgungsspannungsklemme VDD bzw. VSS liegt jeweils eine Konstantstromquelle IR1 bzw. IR2. Parallel zur sourceseitigen Stromquelle IR1 des Transistors M2 liegt die Hilfsstromquelle IH1, deren Strom über den Schalter S1 in die Source von M2 eingespeist werden kann. Entsprechend liegt parallel zur sourceseitigen Stromquelle IR2 des Transistors M3 die Hilfsstromquelle IH2, deren Strom über den Schalter S2 in die Source von M3 eingespeist werden kann.

Eingangsseitig parallel zum Leistungstransistor M1 liegen die beiden Transistoren M11 und M12. Ihr jeweiliger Gateanschluß ist ebenso wie der Gateanschluß von M1 mit dem Ausgang der teuerstufe aus M2 und M3 verbunden. Drainseitig werden M11 und M12 über jeweilige Stromquellen IR3 und IR4 versorgt, die ihrerseits mit der Klemme VDD verbunden sind. Transistor M11 ist sourceseitig direkt an die Klemme VSS angeschlossen, während Transistor M12 sourceseitig über den als Diode geschalteten Transistor M13 mit der Klemme VSS verbunden ist. Der mit K11 bezeichnete Verbindungspunkt der Drain von M11 mit der Stromquele IR3 ist mit einer Schaltanordnung SV1 verbunden, die den Schalter S1 steuert. In entsprechender Weise ist der als K12 bezeichnete Verbindungspunkt der Drain von M12 mit der Stromquelle IR4 mit der Schaltanordnung SV2 verbunden, die den Schalter S2 steuert. Die Schaltanordnung SV1 bzw. SV2 kann als einfacher Inverter ausgeführt sein, wozu vorzugsweise zwei komplementäre Transistoren in entsprechender Weise wie die Transistoren M2 und M3 zusammengeschaltet werden, deren Ausgangskreise von den Klemmen VDD bzw. VSS der Versorgungsspannungsquelle gespeist werden. Anstelle eines Inverters kann die Schaltanordnung SV1 bzw. SV2 auch durch jeweils einen Komparator realisiert sein, die vorzugsweise an jeweils an einem Eingang entsprechende Referenzspannungen aufweisen. Beispielsweise kann SV1 als nichtinvertierender Komparator geschaltet sein, während SV2 als invertierender Komparator ausgeführt sein kann, jeweils bezogen auf die Knoten K11 bzw. K12. Die Ausgänge der jeweiligen Inverter bzw. Komparatoren steuern dann die Schalter S1 bzw. S2. Üblicherweise sind die Schalter S1 bzw. S2 durch Transistoren realisiert, wobei S1 durch einen p-Kanal-Transistor und S2 durch einen n-Kanal-Transistor ausgeführt sein kann.

Die Funktion der Schaltung gemäß Figur 1 wird nachfolgend erläutert. Im ausgeschalteten Zustand des Leistungstransistors M1 befindet sich die Eingangsklemme E der Steuerstufe auf logisch hohem Potential. Das bedeutet, daß der Transistor M2 gesperrt ist, während Transistor M3 leitet. Das Gate des Leistungsschalters M1 ist entladen und die eingangsseitig parallel geschalteten Transistoren M11 und M12 sind gesperrt. Entsprechend liegt der Knoten K11 auf logisch hohem Potential, das mit Hilfe der Schaltanordnung SV1 zum Schließen des Schalters S1 dient. Dies ist beispielsweise dann der Fall, wenn SV1 als Inverter und S1 als p-Kanal-Transistor ausgeführt ist. Entsprechend befindet sich der Knoten K12 ebenfalls auf hohem Potential, das mit Hilfe der Schaltanordnung SV2 zur Öffnung des Schalters S2 dient. Dies ist dann erfüllt, wenn SV2 als Inverter und S2 als n-Kanal-Transistor ausgeführt sind.

Mit Beginn eines Einschaltvorgangs wird das Potential VE an der Klemme E auf logisch D gelegt, Figur 2a). Der Transistor M2 schaltet durch, während Transistor M3 gesperrt wird. Da der Schalter S1 geschlossen ist, laden die Ströme der Konstantstromquelle IR1 und der Hilfsstromquelle IH1 die Gate- bzw. Gate-Source-Kapazität des Leistungstransistors M1 auf. Ebenfalls aufgeladen werden die wesentlichen kleineren Kapazitäten der Transistoren M11 und M12. Damit steigt das Potential VG am Gateknoten G, Figur 2b). Sobald das Potential VG die Einsatzspannung des Transistors M11 erreicht, schaltet dieser durch und das Potential VK11 am Knoten K11 wird logisch 0, Figur 2c). Entsprechend wird über die Schaltanordnung SV1 der Schalter S1 geöffnet, so daß die Hilfsstromquelle IH1 keinen weiteren Strom in die Steuerstufe einspeisen kann. Die Steuerstufe wird deshalb nurmehr durch die Konstantstromquelle IR1 gespeist.

Die Dimensionierung der Stromquellen IR1 und IH2 sowie der Einsatzspannungen der Transistoren erfolgt so, daß die im wesentlichen zur Umladung der Gatekapazitäten erforderliche Verzögerungszeit klein wird und bei der eigentlichen Anstiegszeit der Schaltflanke keine Störstrahlung auftritt. Idealerweise ist deshalb der Strom der Hilfsstromquelle IH1 wesentlich größer als der Strom der Konstantstromquelle IR1. Die Einsatzspannung bzw. Schaltschwelle des als weiteren Schalter anzusehenden Transistors M11 wird im wesentlichen auf die parasitären Umladeeffekte des MOS-Leistungstransistors abgestimmt. Entsprechend wirken die Addition der beiden von den Stromquellen IR1 und IH1 gelieferten Ströme bei der Umladung der Gatekapazitäten während der Verzögerungszeit td1 zusammen. Nach dem Abschalten der Hilfsstromquelle IH1 trägt lediglich die Stromquelle IR1 zur Aufladung des Gates von M1 bei. Die Stromquelle IR1 wird dabei so dimensioniert, daß während der Anstiegszeit tr des durch den Leistungstransistor M1 fließenden Laststroms IL keine oder nur die zulässige Störstrahlung abgegeben wird, Figur 2e).

Wie anhand der Figuren 2b) bis 2d) zu erkennen ist, liegt die Einsatzspannung des Transistors M12 höher als die Einsatzspannung des Transistors M11. Entsprechend schaltet Transistor M12 bei einem gegenüber Transistor M11 höheren Gatepotential VG durch, wodurch das Potential VK12 am Knoten K12 logisch 0 wird. Im Ausführungsbeispiel gemäß Figur 1 wird die höhere Einsatzspannung des Transistors M12 durch den als Diode geschalteten Transistor M13 erreicht. Da für die Funktion der Schaltung nur wesentlich ist, daß die Schaltschwelle des durch den Transistor M12 realisierter weiteren Schalters oberhalb der Schaltschwelle der Transistoren M1 und M11 liegen muß, kann statt des Transistors M13 auch eine entsprechende Dimensionierung von M12 und des Referenzstroms IR4 oder ein Transistor M12 mit einer höheren Einsatzspannung vorgesehen sein. Die Einsatzspannung des Transistors M1 entspricht vorzugsweise der Einsatzspannung des Transistors M11, Figur 2.

Sobald Transistor M12 durchgeschaltet hat, liegt der Knoten K12 auf logisch niedrigem Potential, so daß die Schaltanordnung SV2 den Schalter S2 schließt. Damit ist der Einschaltvorgang abgeschlossen.

Beim Ausschaltvorgang wird das Potential VE der Klemme E logisch eins. Entsprechend öffnet der Transistor M2 und der Transistor M3 schließt. Damit sinkt gemäß Figur 2b) zunächst das Potential VG am Knoten G. Da der Schalter S2 geschlossen ist, sind sowohl die Konstantstromquelle IR2 als auch die Hilfsstromquelle IH2 aktiv an der Entladung der Gatekapazitäten beteiligt. Vorzugsweise liefert die Stromquelle IH2 einen wesentlich höheren Strom als die Stromquelle IR2. Entsprechend können die Gatekapazitäten relativ schnell entladen werden, so daß die Verzögerungszeit klein bleibt.

Bei Erreichen der Einsatzspannung des Transistors M12 sperrt dieser, so daß das Potential des Knotens K12 logisch eins wird und über die Schaltanordnung SV2 der Schalter S2 geöffnet wird. Damit steht nur noch der Strom der Konstantstromquelle IR2 zur weiteren Entladung des Gates von M1 zur Verfügung. Dieser Strom wird so gewählt, daß während der Abfallzeit tf keine oder nur die zulässige Störstrahlung auftritt. Bei Erreichen ihrer jeweiligen Einsatzspannung sperren die Transistoren M1 bzw. M11. Dadurch wird die Last RL stromfrei und der Laststrom IL zu Null. Weiterhin nimmt der Knoten K11 logisch hohes Potential an, so daß über die Schaltanordnung SV1 der Schalter S1 geschlossen wird. Die Verzögerungszeit td2 kann insgesamt klein bleiben, während die Abfallzeit tf im wesentlichen nicht zur Abgabe von Störstrahlung führt.

Vorzugsweise kann vorgesehen sein, die Transistoren M1 und M11 sowie M12 baugleich auszuführen nach Art bzw. dem Prinzip eines Stromspiegels, so daß die Flächen der Transistoren M11 bzw. M12 sehr viel kleiner als die Fläche des Transistors M1 sind. Die Funktion der Schaltung wird beim Einsatz dieses Stromspiegelungsprinzips unabhängig von Temperatur- und Fertigungsschwankungen der Transistoren M1, M11 und M12.

Es ist ohne weiteres klar, daß die erfindungsgemäße Schaltungsanordnung anstelle von n-Kanal-Schalttransistoren in gleicher Weise auch p-Kanal-Schalttransistoren enthalten kann. Ebenso kann die Gate-Steuerspannung auch von einer Ladungspumpe erzeugt werden, so daß die Schaltungsanordnung für alle bekannten MOS-Leistungstechnologien einsetzbar ist, insbesondere für Low-Side- und High-Side-Switches, also für Leistungsschalter, die gemäß Figur 1 zwischen der Last und dem negativen Pol der Versorgungsspannungsquelle bzw. zwischen der Last und dem positiven Pol der Versorgungsspannungsquelle angeordnet sind.

## Patentansprüche

1. Schaltungsanordnung zur Ansteuerung eines MOS-Leistungstransistors, dessen Ausgangskreis in Reihe zu einer Last liegt und dessen Eingangskreis von einer Steuerstufe gesteuert wird, wobei die Steuerstufe ein CMOS-Inverter (M2, M3) ist, der bei jedem Steuervorgang für den MOS-Leistungstransistor (M1) von einer Konstantstromquelle (IR1; IR2) und einer parallel dazu liegenden schaltbaren Hilfsstromquelle (IH1; IH2) gespeist wird, die eine vorgegebene Zeit (td1; td2) nach Beginn des Steuervorgangs abgeschaltet wird.

2. Anordnung nach Anspruch 1,
**dadurch gekennzeichnet,**
daß die Hilfsstromquelle (IH1; IH2) mit einem Schalter (S1; S2) schaltbar ist, der von einem von der Steuerstufe (M2, M3) gesteuerten weiteren Schalter (Mll; M12) betätigbar ist.

3. Anordnung nach Anspruch 1 oder 2,
**dadurch gekennzeichnet,**
daß der weitere Schalter ein Schalttransistor (Mll, M12) ist, dessen Eingangskreis parallel zum Eingangskreis des MOS-Leistungstransistors (M1) liegt.

4. Anordnung nach Anspruch 2 oder 3,
**dadurch gekennzeichnet,**
daß die Schaltschwelle des weiteren Schalters (Mll, M12) im wesentlichen auf parasitäre Umladeeffekte des Eingangskreises des MOS-Leistungstransistors (M1) bei einem Steuervorgang abgestimmt ist.

5. Anordnung nach einem der vorhergehenden Ansprüche,
**dadurch gekennzeichnet,**
daß sowohl Einschalt- als auch Ausschaltsteuervorgänge des MOS-Leistungstransistors mit jeweiligen schaltbaren Hilfsstromquellen gesteuert werden.

6. Anordnung nach einem der Ansprüche 3 bis 5,
**dadurch gekennzeichnet,**
daß die Schaltschwelle des bei einem Ausschaltsteuervorgang des MOS-Leistungstransistors aktiven Schalttransistors (M12) höher als die Schaltschwelle des MOS-Leistungstransistors (M1) ist.

7. Anordnung nach einem der Ansprüche 2 bis 6,
**dadurch gekennzeichnet,**
daß der Schalttransistor und der MOS-Leistungstransistor im wesentlichen baugleich nach Art von Stromspiegeltransistoren ausgeführt sind.

8. Anordnung nach einem der vorhergehenden Ansprüche,
**dadurch gekennzeichnet,**
daß der Strom der Hilfsstromquelle wesentlich größer als der Strom der Konstantstromquelle ist.

9. Anordnung nach einem der Ansprüche 2 bis 8,
**dadurch gekennzeichnet,**
daß zwischen dem weiteren Schalter (Mll, M12) und dem Schalter (S1, S2) eine Schaltanordnung (SV1, SV2) mit vorgebbarer Schaltschwelle liegt.

## Claims

1. Circuit arrangement for driving a MOS power transistor, the output circuit of which is connected in series with a load and the input circuit of which is controlled by a control stage, the control stage being a CMOS invertor (M2, M3) which, during every control operation for the MOS power transistor (M1), is fed by a constant-current source (IR1; IR2) and a switchable auxiliary current source (IH1; IH2) which is connected in parallel with the said constant-current source and is switched off a predetermined time (td1; td2) after the beginning of the control operation.

2. Arrangement according to Claim 1, characterized in that the auxiliary current source (IH1; IH2) can be switched by a switch (S1; S2) which can be actuated by a further switch (M11; M12) which is controlled by the control stage (M2, M3).

3. Arrangement according to Claim 1 or 2, characterized in that the further switch is a switching transistor (M11, M12), the input circuit of which is connected in parallel with the input circuit of the MOS power transistor (M1).

4. Arrangement according to Claim 2 or 3, characterized in that the switching threshold of the further switch (M11, M12) is essentially coordinated with parasitic charge-reversal effects of the input circuit of the MOS power transistor (M1) during a control operation.

5. Arrangement according to one of the preceding claims, characterized in that both turn-on and turn-off control operations of the MOS power transistor are controlled with respective switchable auxiliary current sources.

6. Arrangement according to one of Claims 3 to 5, characterized in that the switching threshold of the switching transistor (M12) which is active during a turn-off control operation of the MOS power transistor is higher than the switching threshold of the MOS power transistor (M1).

7. Arrangement according to one of Claims 2 to 6, characterized in that the switching transistor and the MOS power transistor are designed essentially with the same structure after the manner of current mirror transistors.

8. Arrangement according to one of the preceding claims, characterized in that the current of the auxiliary current source is substantially greater than the current of the constant-current source.

9. Arrangement according to one of Claims 2 to 8, characterized in that a switching arrangement (SV1, SV2) having a predeterminable switching threshold is connected between the further switch (M11, M12) and the switch (S1, S2).

## Revendications

1. Circuit pour la commande d'un transistor de puissance MOS dont le circuit de sortie est monté en série par rapport à une charge et dont le circuit d'entrée est commandé par un étage de commande, l'étage de commande étant un inverseur CMOS (M2, M3) qui à chaque opération de commande du transistor de puissance MOS (M1) est alimenté par une source de courant constant (IR1 ; IR2) et une source de courant auxiliaire (IH1 ; IH2) commutable montée en parallèle par rapport à cette dernière, qui, passé un temps donné (td1 ; td2) après le début de l'opération, est coupée.

2. Circuit selon la revendication 1, caractérisé en ce que la source de courant auxiliaire (IH1 ; IH2) peut être commutée à l'aide d'un commutateur (S1 ; S2), lequel est manoeuvrable par un commutateur (M11 ; M12) supplémentaire commandé par l'étage de commande (M2, M3).

3. Circuit selon la revendication 1 ou 2, caractérisé en ce que le commutateur supplémentaire est un transistor de commutation (M11, M12) dont le circuit d'entrée est parallèle au circuit d'entrée du transistor de puissance MOS (M1).

4. Circuit selon la revendication 2 ou 3, caractérisé en ce que le seuil de commutation du commutateur (M11, M12) supplémentaire est adapté essentiellement à des effets d'inversion de charge parasitaires du circuit d'entrée du transistor de puissance MOS (M1) lors d'une opération de commande.

5. Circuit selon l'une des revendications précédentes, caractérisé en ce qu'aussi bien les opérations de commande de mise en circuit que les opérations de commande de mise hors circuit du transistor de puissance MOS sont commandées par des sources de courant auxiliaire commutables respectives.

6. Circuit selon l'une des revendications 3 à 5, caractérisé en ce que le seuil de commutation du transistor de commutation (M12) actif lors d'une opération de commande de mise hors circuit du transistor de puissance MOS est plus élevé que le seuil de commutation du transistor de puissance MOS (M1).

7. Circuit selon l'une des revendications 2 à 6, caractérisé en ce que le transistor de commutation et le transistor de puissance MOS sont essentiellement de construction identique, à la manière de transistors à miroir de courant.

8. Circuit selon l'une des revendications précédentes, caractérisé en ce que le courant fourni par la source de courant auxiliaire est nettement plus fort que le courant fourni par la source de courant constant.

9. Circuit selon l'une des revendications 2 à 8, caractérisé en ce qu'un circuit (SV1, SV2) à seuil prédéfinissable est placé entre le commutateur supplémentaire (M11, M12) et le commutateur (S1, S2).
